# EUROPEAN PATENT APPLICATION

(11) **EP 2 175 706 A1**
(43) Date of publication of application: **14.04.2010**
(21) Application number: 08791641.7
(22) Date of filing: 25.07.2008
(51) Int. Cl.: H05K 3/46

(54) **COMPOSITE FOR MULTILAYER CIRCUIT BOARD**

(30) Priority: 27.07.2007 JP 2007196336
(71) Applicant: Zeon Corporation, Tokyo 100-8246 (JP)
(72) Inventor: KOJIMA, Kiyoshige, Tokyo 100-8246 (JP); KODEMURA, Junji, Tokyo 100-8246 (JP)
(74) Representative: Vossius & Partner
(86) International application number: PCT/JP2008/063397
(87) International publication number: WO 2009/017051

(57) **Abstract**

A crosslinkable and polymerizable composition containing a monomer and a cross-linking agent is applied onto a metal foil to form a coated film of the composition, and heat is applied to the coated film to firstly bulk polymerize the entire coated film of the crosslinkable and polymerizable composition. Then, by applying heat to the coated film from the metal foil side, cooling a surface far from the metal foil as needed, and subjecting a limited region adjacent to the metal foil in the thickness direction of the coated film to a cross-linking reaction, a composite for multilayer circuit board is obtained, in which the metal foil layer, a hard resin layer containing a hard resin obtained by bulk polymerization reaction and cross-linking reaction, and an adhesive resin layer containing an adhesive resin obtained by bulk polymerization reaction are laminated in this order.

## Description

### TECHNICAL FIELD

The present invention relates to a composite for multilayer circuit board. More in detail, the present invention relates to a composite for multilayer circuit board to be used for manufacturing, with high yield rate, a multilayer circuit board with high adhesion properties between layers, small displacement in simultaneous lamination and high reliability.

### BACKGROUND ART

A multilayer printed wiring board is a laminated body formed by alternately laminating conductor circuits and inter-level insulating layers. The laminated body has a surface wiring pattern on the face thereof and inner layer wiring patterns between the inter-level insulating layers. Regarding these wiring patterns, an electrical connection between each two or more inner layer wiring patterns or between each inner layer and the surface wiring pattern is achieved by providing a through hole formed in the thickness direction of the laminated body or a via hole formed in each inter-level insulating layer. Herein, the structure in which certain two or more wiring patterns are electrically connected to each other via a via hole is referred to as interstitial via hole (IVH) structure.

A multilayer circuit board with the IVH structure is a structure suitable to realize a downsized and highly densed electronic device, and for manufacturing such a multilayer circuit board, various materials and manufacturing methods are being studied.

Patent Document 1 discloses a single-sided circuit film having a circuit conductor on one face of a plastic insulating film, an adhesive agent layer on the other face, and a through stud of a conductive material formed on a position to conduct between layers. In this laminated film, a polyimide resin film is used as the plastic insulating film, and an imide-based adhesive is used as the adhesive agent layer. As a manufacturing method of this laminated film, a method which includes forming a film of copper or the like by physical vapor deposition method on one face of the polyimide resin film and then coating the imide-based adhesive agent as the adhesive agent layer on the other face, and a method which includes casting a polyimide precursor on a copper foil and imidizing the precursor and then coating an epoxy-based adhesive agent onto the face of the obtained imide insulating film side are also disclosed.

Patent Document 2 and Patent Document 3 disclose a sheet material formed by laminatedly forming a copper foil on one face of a hard insulating layer formed of a cured article of epoxy resin composition including a glass woven fabric as a base material, and forming an adhesive agent layer including an epoxy resin on the other face.

Patent Document 4 discloses a single-sided copper-clad laminated board provided by laminating a hard board obtained through curing a glass fabric epoxy resin, a glass nonwoven fabric epoxy resin, a glass fabric bismaleimide-triazine resin, an aramid nonwoven fabric epoxy resin or the like into a plate-like shape, a metal foil formed on one face of the hard board, and a layer of a resin adhesive agent of epoxy-based, polyimide-based, bismaleimide-triazin-based, acrylate-based, or phenol-based formed on the other face of the hard board.
[Patent Document 1] Japanese Patent Publication (A) No. 5-198946
[Patent Document 2] Japanese Patent Publication (A) No. 2005-158974
[Patent Document 3] Japanese Patent Publication (A) No. 2004-327510
[Patent Document 4] International Publication No. WO97/048620

### DISCLOSURE OF THE INTENTION

### PROBLEM TO BE SOLVED BY THE INVENTION

According to studies by the present inventors, however, there was a case that adhesion properties between layers were low in the time of trying to obtain a multilayer circuit board by pressure bonding the composite such as the laminated film disclosed in the above-mentioned patent documents through a heat pressing or the like. In addition, there was a case that a displacement of positioning occurred when a plurality of such composites were laminated and pressure bonded simultaneously (simultaneous lamination). Moreover, because the above composite was manufactured through forming a hard resin layer while heat pressing a partially-cured curable resin and volatilizing a solvent, then forming a conductor layer on one face of the hard resin layer, and forming an adhesive agent layer on the other face of the hard resin layer, the process thereof became complicated and the productivity was extremely low.

It is an object of the present invention to provide a composite for multilayer circuit board to be used for manufacturing, with high productivity and high yield rate, a multilayer circuit board with high adhesion properties between layers, small displacement in simultaneous lamination and high reliability, and a manufacturing method thereof.

### MEANS FOR SOLVING THE PROBLEMS

As a result of intensive studies to achieve the above object, the present inventors have found out that, by using a composite for multilayer circuit board comprising a layer of metal foil, a hard resin layer containing a hard resin obtained by bulk polymerization reaction and cross-linking reaction, and an adhesive resin layer containing an adhesive resin obtained by bulk polymerization reaction, those layers being laminated in this order, a multilayer circuit board with high adhesion properties between layers, small displacement in simultaneous lamination (superior in lamination properties) and high reliability could be manufactured with high productivity and high yield rate. Based on such findings and knowledge, the invention has been completed.

That is, the present invention includes the following aspects thereof.
(1) A composite for multilayer circuit board, comprising: a layer of metal foil; a hard resin layer containing a hard resin obtained by bulk polymerization reaction [1] and cross-linking reaction; and an adhesive resin layer containing an adhesive resin obtained by bulk polymerization reaction [2], the layer of metal foil, the hard resin layer and the adhesive resin layer being laminated in this order.
(2) The above composite for multilayer circuit board, wherein at least either one of the hard resin layer or the adhesive resin layer includes cycloolefin polymer.
(3) The above composite for multilayer circuit board, wherein the adhesive resin layer further contains a cross-linking agent [2].

(4) A manufacturing method of a composite for multilayer circuit board, comprising: forming an intermediate composite (A) by integrating a layer of metal foil and a crosslinkable resin layer containing a resin obtained by bulk polymerization reaction and a cross-linking agent [1]; and applying heat to the intermediate composite (A) from the layer of metal foil side to subject a limited region of the crosslinkable resin layer adjacent to the metal foil to cross-linking reaction thereby the crosslinkable resin layer becomes to comprise a hard resin layer containing a hard resin obtained by bulk polymerization reaction and cross-linking reaction and an adhesive resin layer containing an adhesive resin obtained by bulk polymerization reaction.
(5) The above manufacturing method of a composite for multilayer circuit board, wherein the cross-linking reaction of the intermediate composite (A) takes place under a condition where a surface of the crosslinkable resin layer far from the layer of metal foil has a temperature lower than or equal to a one-minute half-life temperature of the cross-linking agent [1] .
(6) The above manufacturing method of a composite for multilayer circuit board, wherein the intermediate composite (A) is obtained by applying a crosslinkable and polymerizable composition containing a bulk polymerizable monomer and the cross-linking agent [1] on the metal foil to form a coated film of the composition and applying heat to the coated film to be bulk polymerized.

(7) A manufacturing method of a composite for multilayer circuit board, comprising: forming an intermediate composite (B) by arranging a layer of metal foil, a crosslinkable resin layer containing a resin obtained by bulk polymerization reaction [3] and a cross-linking agent (α), and an adhesive resin layer containing an adhesive resin obtained by bulk polymerization reaction [4] in this order to be integrated to each other; and heating the intermediate composite (B) to cross-link at least in part of the resin contained in the crosslinkable resin layer such that the crosslinkable resin layer becomes to be a hard resin layer containing a hard resin obtained by bulk polymerization reaction and cross-linking reaction.
(8) The above manufacturing method of a composite for multilayer circuit board, wherein the adhesive resin layer contains a cross-linking agent (β) having a one-minute half-life temperature higher than that of the cross-linking agent (α).
(9) The above manufacturing method of a composite for multilayer circuit board, wherein the intermediate composite (B) is obtained by: applying a crosslinkable and polymerizable composition (a) containing a bulk polymerizable monomer and the cross-linking agent (α) on the metal foil; applying a polymerizable composition (b) containing a bulk polymerizable monomer on the crosslinkable and polymerizable composition (a) applied on the metal foil; and bulk polymerizing the crosslinkable and polymerizable composition (a) and the polymerizable composition (b) to form respectively the crosslinkable resin layer and the adhesive resin layer.
(10) The above manufacturing method of a composite for multilayer circuit board, wherein the intermediate composite (B) contains a fibrous material in the crosslinkable resin layer and/or the adhesive resin layer, and the intermediate composite (B) is obtained by: applying a crosslinkable and polymerizable composition (a) containing a bulk polymerizable monomer and the cross-linking agent (α) on one surface of the fibrous material; applying a polymerizable composition (b) containing a bulk polymerizable monomer on the other surface of the fibrous material; laminating the metal foil on the crosslinkable and polymerizable composition (a) applied on the one surface of the fibrous material; and bulk polymerizing the crosslinkable and polymerizable composition (a) and the polymerizable composition (b) to form respectively the crosslinkable resin layer and the adhesive resin layer.
(11) The above manufacturing method of a composite for multilayer circuit board, wherein the intermediate composite (B) is obtained by: applying a crosslinkable and polymerizable compositions (a) containing a bulk polymerizable monomer and the cross-linking agent (α) on the metal foil and then forming the crosslinkable resin layer through a bulk polymerization reaction [3]; and applying a polymerizable composition (b) containing a bulk polymerizable monomer on the crosslinkable resin layer formed on the metal foil and then forming the adhesive resin layer through a bulk polymerization reaction [4].

(12) A manufacturing method of a composite for multilayer circuit board, comprising: applying a crosslinkable and polymerizable composition (a) containing a bulk polymerizable monomer and a cross-linking agent (α) on a metal foil and then forming a crosslinkable resin layer through a bulk polymerization reaction [5]; cross-linking at least in part of the crosslinkable resin layer to form a hard resin layer containing a hard resin obtained by bulk polymerization reaction and cross-linking reaction; and applying a polymerizable composition (b) containing a bulk polymerizable monomer on the hard resin layer and then forming an adhesive resin layer containing an adhesive resin obtained by bulk polymerization reaction through a bulk polymerization reaction [6].
(13) A single sided circuit board for multilayer circuit board, wherein a conductive circuit is formed by patterning the layer of the metal foil of the above composite for multilayer circuit board, a via hole is formed to penetrate through the hard resin layer and the adhesive resin layer and to make the conductive circuit exposed at a bottom surface side of the via hole, and a conductor is given into the via hole.
(14) A method of manufacturing a multilayer circuit board comprising a plurality of circuit boards, wherein the method includes overlapping two or more of the above single sided circuit board for multilayer circuit board or overlapping the single sided circuit board for multilayer circuit board and other circuit board, followed by heat pressing to laminate.

### EFFECTS OF THE INTENTION

The adhesive resin layer contained in the composite for multilayer circuit board according to the present invention scarcely includes a volatile ingredient such as a solvent, because of being obtained directly through bulk polymerization reaction. As a result, it is possible to provide a multilayer circuit board with superior lamination properties at the time of heat pressing and high adhesion properties. Moreover, the hard resin layer contained in the composite for multilayer circuit board according to the present invention is obtained directly through bulk polymerization reaction and cross-linking reaction. This hard resin layer has small dielectric tangent, and good high frequency electrical insulation properties.
In the manufacturing method of a composite for multilayer circuit board according to the present invention, the adhesive resin layer and the hard resin layer can be directly obtained through bulk polymerization reaction, and therefore a process for removing a solvent is unnecessary and the method provides good productivity.

According to the composite for multilayer circuit board according to the present invention, it is possible to manufacture, with high productivity and high yield rate, a multilayer circuit board with high adhesion properties between layers, small displacement at the time of simultaneous lamination, and high reliability.

### BRIEF DESCRIPTION OF DRAWING

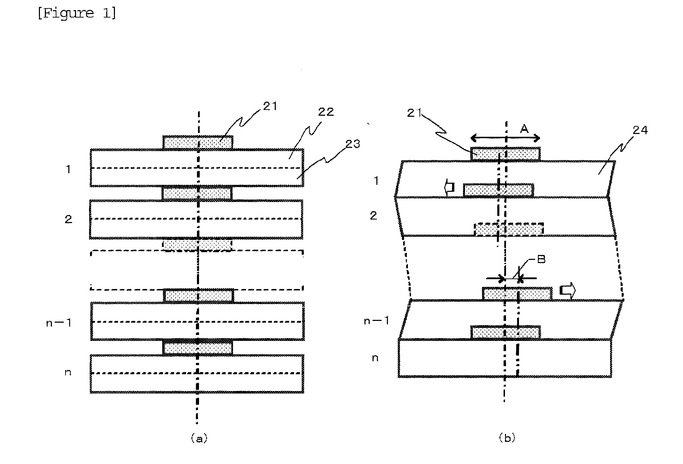

[FIG. 1] Figures 1(a) and 1(b) illustrate a method of obtaining a displacement in a multilayer circuit board.

### DESCRIPTION OF REFERENCE NUMERALS

A: wiring width
B: displacement
1, 2, n-1, n: number of layer
21: wiring
22: hard resin layer (cross-linked resin layer)
23: adhesive resin layer (not-cross-linked resin layer)
24: cross-linked resin layer

### BEST MODE FOR CARRYING OUT THE INVENTION

The composite for multilayer circuit board according to the present invention is provided by laminating a layer of metal foil, a hard resin layer containing a hard resin obtained by bulk polymerization reaction and cross-linking reaction, and an adhesive resin layer containing an adhesive resin obtained by bulk polymerization reaction, in this order.

### (Layer of metal foil)

The layer of metal foil is to be an inner layer wiring or a surface wiring of a multilayer circuit board. The metal foil is not particularly limited so long as it has an electrical conductivity. A foil of iron, stainless steel, copper, aluminum, nickel, chromium, gold, silver, etc. may be generally used as the metal foil. From a view point of workability, it is preferred that the thickness of the metal foil is 1 mem or less in general, preferably 1 to 500 µm, more preferably 2 to 100 µm, and furthermore preferably 3 to 50 µm. Preferably, such metal foil has a flat and smooth surface. Alternatively, such metal foil may have a surface treated by a roughening process or a surface treated by using silane coupling agent.

### (Hard resin layer)

The hard resin layer is obtained by subjecting a polymerizable composition (hereinafter referred to as "polymerizable composition for hard resin layer") as a precursor thereof to bulk polymerization reaction and cross-linking reaction. The hard resin layer is a layer being insoluble and maintaining the form thereof even if the layer is immerse in a solvent in which a not-cross-linked resin to be the hard resin is soluble. Although such solvents are different depending on the variety of the not-cross-linked resins, in case that the not-cross-linked resin is a polymer of cycloolefin compound for example, toluene or cyclohexane is preferable. In case that the not-cross-linked resin is a polymer of styrenes, toluene or tetrahydrofuran is preferable. In case that the not-cross-linked resin is a polymer of acrylate compound, acetone or ethyl acetate is preferable. Herein, when the hard resin layer is immersed in the solvent during 5 minutes at a room temperature, decreasing of a resin amount may be observed generally in a range of 20 wt% or less, preferably 10 wt% or less. However, such an extent of decreasing of the resin amount allows the hard resin layer to maintain the form thereof, and therefore is acceptable for the hard resin layer according to the present invention. It is to be noted that a layer in which a polymerizable composition is bulk polymerized but not cross-linked is referred to as "crosslinkable resin layer" in the present invention.

Although the polymerizable composition for hard resin layer is not particularly limited, it is polymerizable and crosslinkable and is capable of being shaped in a form of layer. As the polymerizable composition for hard resin layer, for example, a composition containing polymerizable monomer, polymerization initiator and cross-linking agent may be mentioned.

While the polymerizable monomer contained in the polymerizable composition for hard resin layer is not particularly limited, it is a monomer which is bulk polymerizable and capable of forming an electrically insulating polymer composing of the hard resin layer. As examples thereof, an acrylate compound, styrenes, a cycloolefin compound, etc. may be mentioned.
Among these examples, a cycloolefin compound (cycloolefin monomer) is preferred as the polymerizable monomer because superior in insulation properties to high frequency current.

The cycloolefin monomer is a compound having a ring structure in which a series of carbon atoms are connected to form a loop, the ring including carbon-carbon double bond to be opened by metathesis reaction, thereby enabling to produce a polymer. As examples of such cycloolefin monomer, a norbornene-based monomer and a monocyclic cycloolefin may be mentioned, preferred is the norbornene-based monomer.

The norbornene-based monomer is a monomer which includes a norbornene ring. As specific examples thereof, norbornenes, dicyclopentadienes, tetracyclododecenes, etc. may be mentioned. The norbornene-based monomer may include, as a substituted group, a hydrocarbon group such as an alkyl group, an alkenyl group, an alkylidene group or an aryl group, or a polar group such as a carboxyl group or an acid anhydride group as a substituted group. Further, the norbornene-based monomer may further have another double bond in addition to the double bond in the norbornene ring. Among these examples, preferred is a norbornene-based polymer without the polar group, namely is formed only from carbon atoms and hydrogen atoms. The number of rings constituting the norbornene-based monomer is preferably 3 to 6, more preferably 3 or 4, and particularly preferably 4.

As the norbornene-based polymer without polar group include, 2-norbornene, 5-cyclohexyl-2-norbornene, 5-ethylidene-2-norbornene, 5-vinyl-2-norbornene, 5-phenyl-2-norbornene, tetracyclo[9.2.1.0^{2,10}.0^{3,8}] tetradeca-3,5,7,12-tetraene (also referred to as 1,4-methano-1,4,4a,9a-tetrahydro-9H-fluorene), tetracyclo [10.2.1.0^{2,11}. 0^{4,9}]pentadeca-4,6,8,13-tetraene (also referred to as 1,4-methano-1,4,4a,9,9a,10-hexahydroanthracene), and other norbornens;

5-cyclopentyl-2-norbornene, 5-cyclohexenyl-2-norbornene, 5-cyclopentenyl-2-norbornene, and other norbornenes having 3 rings; dicyclopentadiene, methyldicyclopentadiene, dihydrodicyclopentadiene (also referred to as tricyclo[5.2.1.0^{2,6}]deca-8-ene), and other dicyclopentadienes having 3 rings;

tetracyclo[6.2.1.1^{3,6}.0^{2,7}]dodeca-4-ene, 9-ethylidenetetracyclo[6.2.1.1^{3,6}.0^{2,7}] dodeca-4-ene, 9-vinyltetracyclo [6.2.1.1^{3,6}.0^{2,7}] dodeca-4-ene, 9-phenyltetracyclo[6.2.1.1^{3,6}.0^{2,7}] dodeca-4-ene, and other tetracyclododecenes;

tetracyclo[6.2.1.1^{3,6}.0^{2,7}] dodeca-9-ene-4-carboxylic acid, tetracyclo[6.2.1.1^{3.6}.0^{2,7}] dodeca-9-ene-4,5-dicarroxylic anhydride, 5-norbornene-2-methyl carboxylate, 2-methyl-5-norbornene-2-methyl carboxylate, 5-norbornene-2-ol, 5-norbornene-2-carbonitrile, 7-oxa-2-norbornene, and other norbornene-based monomers which contain polar groups; etc. may be mentioned.

As the monocyclic cycloolefin, cyclobutene, cyclopentene, cyclooctene, cyclododecene, 1,5-cyclooctadiene, and other monocyclic cycloolefins, and derivatives thereof each having a substituted group may be mentioned. Such cycloolefin monomers may be used either alone or two or more kinds in combination. By using two or more kinds of monomers in combination and varying the blend ratio thereof, it is possible to arbitrarily control the glass transition temperature and the melting point of a polymer and a cross-linked product to be obtained. The amount of monocyclic cycloolefins and derivatives thereof is preferably 40 mass % or less, more preferably 20 mass % ore less relative to the total amount of cycloolefin monomers. More than 40 mass % ratio may cause an insufficient heat tolerance of the polymer and the cross-linked product.

In the present invention, the acrylate compound is intended to mean acrylic acid, methacrylic acid, or acrylic acid (or methacrylic acid) ester. As acrylic acid (or methacrylic acid) ester, alkyl ester or alkenyl ester is preferred. Carbon number of alkyl group or alkenyl group of alkyl ester or alkenyl ester is usually 1 to 20, preferably 4 to 18, more preferably 4 to 12, and particularly preferably 4 to 8.
As specific examples of acrylic acid (or methacrylic acid) ester, methyl acrylate (or methacrylate), ethyl acrylate (or methacrylate), n-butyl acrylate (or methacrylate), 2-ethylhexyl acrylate (or methacrylate), n-octyl acrylate (or methacrylate), isooctyl acrylate (or methacrylate), n-decyl acrylate (or methacrylate), n-dodecyl acrylate (or methacrylate), and other acrylic acid (or methacrylic acid) alkyl esters;
allyl acrylate (or methacrylate), butenyl acrylate (or methacrylate), pentenyl acrylate (or methacrylate), hexenyl acrylate (or methacrylate), heptenyl acrylate (or methacrylate), octenyl acrylate (or methacrylate), nonenyl acrylate (or methacrylate), decenyl acrylate (or methacrylate), undecenyl acrylate (or methacrylate), and other acrylic acid (or methacrylic acid) alkenyl esters;
hydroxyethyl acrylate (or methacrylate), hydroxypropyl acrylate (or methacrylate), and other acrylic acid (or methacrylic acid) hydroxyalkyl esters;
N,N-dimethylaminomethyl acrylate (or methacrylate), N,N-dimethylaminoethyl acrylate (or methacrylate), and other acrylic acid (or methacrylic acid) N,N-dimethylaminoalkyl esters;
glycidyl acrylate (or methacrylate), and other epoxy group containing acrylic acid (or methacrylic acid) esters;
polyethylene glycol diacrylate, 1,3-butylene grycol diacrylate, and other diacrylic acid esters;
ethylene dimethacrylate, diethylene glycol dimethacrylate, ethylene glycol dimethacrylate, and other dimethacrylic acid esters;
trimethylolpropane triacrylate, and other triacrylic acid esters;
trimethylolpropane trimethacrylate, and other trimethacrylic acid esters; etc. may be mentioned.

In the present invention, the styrenes are intended to mean compounds each having an aromatic ring and a vinyl group or isopropenyl group bonded to the aromatic ring. As specific examples thereof, styrene, α-methylstyrene, o-methylstyrene, p-methylstyrene, m-methylstyrene, vinyl ethyl benzene, vinyl xylene, p-t-butyl styrene, α-methyl-p-methyl styrene, vinyl naphthalene etc. may be mentioned, and among them, styrene is preferred. In addition, as the styrenes, o-divinylbenzene, p-divinylbenzene, m-divinylbenzene, and other compounds having two or more vinyl groups may be used. Such compounds are preferred because they enable the polymer obtained to have a high cross-linking reactivity.

The polymerization initiator contained in the polymerizable composition for hard resin layer used in the present invention, may be appropriately selected depending on a polymerizable monomer to be used and a pattern of the polymerization reaction. For the above-mentioned cycloolefins, a ruthenium carbene complex may be selected as a preferred polymerization initiator, for example.

The ruthenium carbene complex is a complex having a ruthenium atom as a center atom and a plurality of ions, atoms, polyatomic ions and/or compounds bonded to the ruthenium atom, and having an structure in which a carbene carbon is double bonded to the ruthenium atom (Ru=C).

The ruthenium carbene complex allows to provide a significant productivity improvement of a polymer capable of post-cross-linking and to obtain a polymer less smelly originated from unreacted monomer residues, because of having a remarkable catalytic activity in polymerization. Moreover, the ruthenium carbene complex is relatively stable against oxygen and water in air and hardly inactivated, thereby enabling to produce polymers in the atmosphere.

The ruthenium carbene complex is a compound represented by the following formula (1) or (2), for example.

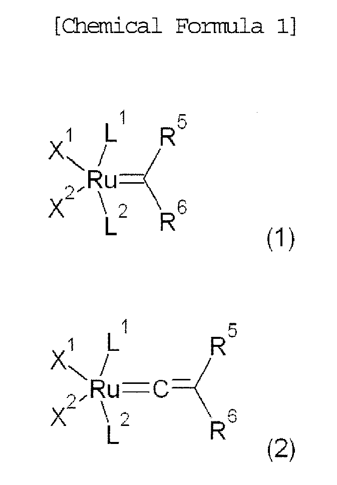

In formula (1) and formula (2), each of R⁵ and R⁶ independently represents a hydrogen atom, a halogen atom, or C₁ to C₂₀ hydrocarbon groups which may contain a halogen atom, an oxygen atom, a nitrogen atom, a sulfur atom, a phosphorus atom or a silicon atom. Each of X¹ and X² independently represents an arbitrary anionic ligand. Each of L¹ and L² independently represents a heteroatom-containing carbene compound or a neutral electron donative compound. In addition, R⁵ and R⁶ may be bonded together to form a ring. Furthermore, R⁵, R⁶, X¹, X², L¹ and L² may be bonded together in any combination to form a multidentate chelated ligand.

The heteroatom is intended to mean an atom in groups 15 and 16 of the periodic table, and N, O, P, S, As, Se atom, etc. may be mentioned as specific examples thereof. Among them, N, O, P, S atom, etc. are preferred, and N atom is particularly preferred, from the viewpoint of obtaining stable carbene compounds.

It is preferred that the heteroatom-containing carbene compound has heteroatoms adjacently bonded to both sides of a carbene carbon, and more preferably has a heterocycic structure formed to contain a carbene carbon atom and heteroatoms located at both sides of the carbene carbon atom. It is additionally preferred that each of the heteroatoms adjacent to the carbene carbon atom has a bulky substituted group.

As the heteroatom-containing carbene compound, a compound represented by the following formula (3) or formula (4) may be mentioned. From the view point of suppressing effectively an increase in viscosity of the polymerizable composition, the compound represented by formula (4) is preferred.

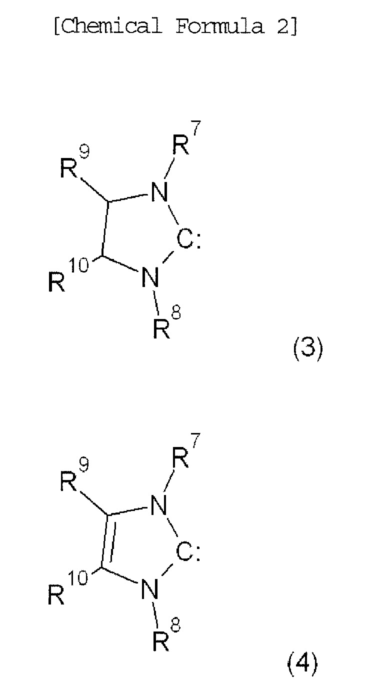

(In the formulae, each of R⁷ to R¹⁰ independently represents a hydrogen atom, a halogen atom, or C₁ to C₂₀ hydrocarbon groups which may contain a halogen atom, an oxygen atom, a nitrogen atom, a sulfur atom, a phosphorus atom or a silicon atom. Herein, R⁷ to R¹⁰ may be bonded together in any combination to form a ring.)

As the compound represented by the above formula (3) or formula (4), 1,3-dimesitylimidazolidin-2-ylidene, 1,3-di(1-adamantyl)imidazolidin-2-ylidene, 1-cyclohexyl-3-mesitylimidazolidin-2-ylidene, 1,3-dimesityloctahydrobenzimidazol-2-ylidene, 1,3-diisopropyl-4-imidazolin-2-ylidene, 1,3-di(1-phenylethyl)-4-imidazolin-2-ylidene, 1,3-dimesityl-2,3-dihydrobenzimidazol-2-ylidene, etc. may be mentioned.

In addition to the compound represented by the above formula (3) or formula (4) , it is also possible to use heteroatom-containing carbene compounds such as 1,3,4-triphenyl-2,3,4,5-tetrahydro-1H-1,2,4-triazol-5-ylidene, 1,3-dicyclohexylhexahydropyrimidin-2-ylidene, N,N,N',N'-tetraisopropylformamidinylidene, 1,3,4-triphenyl-4,5-dihydro-1H-1,2,4-triazol-5-ylidene, and 3-(2,6-diisopropylphenyl)-2,3-dihydrothiazol-2-ylidene.

In the above formula (1) and formula (2), each of the anionic (negative ionic) ligands X¹ and X² is a ligand having a negative electrical charge after being pulled away from the central metal atom, for example, halogen atoms such as F, Cl, Br and I, a diketonate group, a substituted cyclopentadienyl group, an alkoxy group, an aryloxy group, a carboxyl group may be mentioned. Among them, halogen atoms are preferred, and a chlorine atom is more preferred.

In addition, any compound may be adopted as the neutral electron donative compound so long as it is a legand having a neutral electrical charge after being pulled away from the central metal atom. As specific examples thereof, carbonyls, amines, pyridines, ethers, nitriles, esters, phosphines, thioethers, aromatic compounds, olefins, isocyanides, thiocyanates, etc. may be mentioned. Among them, phosphines, ethers and pyridines are preferred, and phosphines are more preferred.

As examples of compounds preferably used as the ruthenium carbene complex, benzylidene(1,3-dimesityl imidazolidine-2-ylidene)(tricyclohexyl phosphine) ruthenium dichloride, benzylidene(1,3-dimesityl-4,5-dibromo-4-imidazoline-2-ylidene) (tricyclohexyl phosphine) ruthenium dichloride, (1,3-dimesityl-4-imidazoline-2-ylidine)(3-phenyl-1H-indene-1-ylidene) (tricyclohexyl phosphine)ruthenium dichloride, (3-butenylidene-2-pyridine)(1,3-dimesityl-4-imidazoline-2-ylidene)(tricyclohexyl phosphine)ruthenium dichloride, benzylidene(1,3-dimesityl imidazolidine-2-ylidene)pyridineruthenium dichloride, (1,3-dimesityl imidazolidine-2-ylidene) (2-phenylethylidene) (tricyclohexyl phosphine) ruthenium dichloride, (1,3-dimesityl-4-imidazoline-2-ylidene)(2-phenylethylidene)(tricyclohexyl phosphine) ruthenium dichloride, (1,3-dimesityl-4,5-dibromo-4-imidazoline-2-ylidene)[(phenylthio)methylene](tricyclohexyl phosphine)ruthenium dichloride, (1,3-dimesityl-4,5-dibromo-4-imidazoline-2-ylidene) (2-pyrolidone-1-ylmethylene)(tricyclohexyl phosphine) ruthenium dichloride, etc. may be mentioned.

These ruthenium carbene complexes may be produced by methods described in, for example, Org. Lett., 1999, vol. 1, pp. 953 and Tetrahedron. Lett., 1999, vol. 40, pp. 2247.

The amount of the ruthenium carbene complex is, in terms of the molar ratio of (ruthenium metal atom : cycloolefin monomer), usually in a range of 1:2,000 to 1:2,000,000, preferably 1:5,000 to 1:1,000,000, and more preferably 1:10,000 to 1:500,000.

For the purpose of controlling the polymerization activity of the ruthenium carbene complex, then improving the rate of polymerization reaction, an activator (co-catalyst) may be optionally used. As the activator, alkylated compounds, halogenated compounds, alkoxylated compounds, and aryloxylated compounds of aluminum, scandium and tin may be mentioned.
The amount of the activator is, in terms of the molar ratio of (ruthenium metal atom : activator), usually in a range of 1:0.05 to 1:100, preferably 1:0.2 to 1:20, and more preferably 1:0.5 to 1:10.

In order to homogeneously disperse the ruthenium carbene complex in the composition, the ruthenium carbene complex may be used in a form of being dissolved or suspended in a solvent.
As the solvent to be used for the ruthenium carbene complex, n-pentane, n-hexane, n-heptane, liquid paraffin, mineral spirits, and other chain structured aliphatic hydrocarbons; cyclopentane, cyclohexane, decahydronaphthalene, hexahydroindene, cyclooctane, and other alicyclic hydrocarbons; benzene, toluene, xylene, and other aromatic hydrocarbons; indene, tetralin, and other hydrocarbons each having an alicyclic ring and an aromatic ring; nitromethane, nitrobenzene, acetonitrile, and other nitrogen-containing hydrocarbons; diethyl ether, tetrahydrofuran, and other oxygen-containing hydrocarbons; etc. may be mentioned. The amount of the solvent is in a range of 0.01 to 10 parts by mass, preferably 0.1 to 5 parts by mass, and particularly preferably 0.5 to 3 parts by mass relative to 100 parts by mass of the polymerizable monomer. The solvent may contain a liquid form anti-aging agent, a liquid form plasticizer, a liquid form elastomer.

In the case that the polymerizable monomer is acrylate compound, as a polymerization catalyst, a radical generator, a cationic polymerization initiator, an anionic polymerization initiator, etc. may be mentioned, and the radical generator is preferred.

In the case that the polymerizable monomer is styrenes, as a polymerization catalyst, a radical generator, a cationic polymerization initiator, an anionic polymerization initiator, a metallocene catalyst, a phenoxy-imin catalyst, etc. may be mentioned, the radical generator, the metallocene catalyst and the phenoxy-imin catalyst are preferred, the radical generator is more preferred.

As radical generators as the polymerization catalysts for the acrylate compounds and the styrenes, conventional known radical generators may be used. For examples, potassium persulfate, sodium persulfate, ammonium persulfate, and other persulfates; hydrogen peroxide; lauroyl peroxide, benzoyl peroxide, di-2-ethylhexyl peroxydicarbonate, t-butylhydro peroxide, t-butylperoxypivalate, cyclohexanone peroxide, cumenehydroperoxide, and other organic peroxides; etc. may be mentioned, and these may be used alone or in a mixture of two or more, or may be used as a redox system in combination with acidic sodium sulfite, sodium thiosulfate, ascorbic acid, and other reduction agents. In addition, 2,2'-azobisisobutyronitrile, 2,2'-azobis(2,4-dimethylvaleronitrile), 2,2'-azobis(4-methoxy-2,4-dimethylvaleronitrile), dimethyl 2,2'-azobisisobutyrate, 4,4'-azobis(4-cyanopentanoic acid), and other azo compounds; 2,2'-azobis(2-aminodipropane)dihydrochloride, 2,2'-azobis(N,N'-dimethyleneisobutylamidine), 2,2'-azobis(N,N'-dimethyleneisobutylamidine)dihydrochloride, and other amidine compounds; etc. may be used. Among them, a radical generator with a one-minute half-life temperature lower than or equal to 150°C is preferred, and that lower than or equal to 130°C is more preferred. It is to be noted that one-minute half-life temperature is intended in the present invention to mean the temperature where a radical generator decomposes and becomes half of the initial amount in one minute.

It is Preferable that the polymerizable composition for hard resin layer may further contain a chain transfer agent for the bulk polymerization reaction. Containing the chain transfer agent allows to suppress the polymerization reaction progressing below room temperature. In addition, the polymerization reaction and the cross-linking reaction are inhibited to simultaneously progress in case of containing the chain transfer agent, and therefore it is possible to regulate the condition for producing the cross-linked resin layer and the adhesive resin layer by appropriately selecting the type and amount of the chain transfer agent.
The chain transfer agent may be selected appropriately depending on the polymerizable monomer to be used. Compounds having vinyl groups may be usually used for cycloolefin monomers.

As the chain transfer agent, one having not only the vinyl group but a group contributing to a cross-linkage hereinafter described is preferred. Specifically, such a group contributing to cross-linkage is a group having a carbon-carbon double bond, and vinyl group, acryloyl group, methacryloyl group, etc. may be mentioned as examples thereof. These groups are preferably located at ends of molecular chains. Particularly a compound represented by the formula of (C):CH₂=CH-Q-Y is preferred. In the formula, Q represents a divalent hydrocarbon group, and Y represents a vinyl group, an acryloyl group or a methacryloyl group. As the divalent hydrocarbon group represented by Q, C₁ to C₂₀ alkylene groups, C₆ to C₂₀ arylene groups, and groups formed by bonding in combination thereof, etc. may be mentioned. Among them, phenylene group, and C₄ to C₁₂ alkylene groups are preferred. Using the chain transfer agent of such structure enables to obtain a highly strengthened composite for multilayer circuit board.
As preferable examples of the chain transfer agent when using cycloolefin monomer as the polymerizable monomer, allyl methacrylate, 3-butene-1-yl methacrylate, hexenyl methacrylate, undecenyl methacrylate, decenyl methacrylate, and other compounds with Y of methacryloyl group; allyl acrylate, 3-butene-1-yl acrylate, and other compounds with Y of acryloyl group; divinyl benzene, and other compounds with Y of vinyl group; etc. may be mentioned. Among them, undecenyl methacrylate, hexenyl methacrylate and divinylbenzene are particularly preferred.

As additional examples of compounds used as the chain transfer agent, 1-hexene, 2- hexane, and other aliphatic olefins; styrene, and other olefins having an aromatic group; vinyl cyclohexane, and other olefins having an alicyclic hydrocarbon group; ethyl vinyl ether, and other vinyl ethers; methyl vinyl ketone, 1,5-hexadiene-3-one, 2-methyl-1,5-hexadiene-3-one ,and other vinyl ketones; styryl acrylate, ethylene glycol diacrylate, and other acrylic acid esters; allyl trivinyl silane, allyl methyl divinyl silane, allyl dimethyl vinyl silane, and other silanes; glycidyl acrylate, and allyl glycidyl ether; allyl amine, 2-(diethylamino)ethanol binyl ether, 2-(diethylamino)ethyl acrylate, and 4-vinyl aniline; etc. may be mentioned.

When using acrylate compounds or styrenes as the polymerizable monomers, as chain transfer agents, lauryl mercaptan, octyl mercaptan, 2-mercaptoethanol, thioglycolic acid octyl, 3-mercaptopropionic acid, α-methylstyrene dimer etc. may be used.

The amount of the chain transfer agent is usually 0.01 to 10 mass %, and preferably 0.1 to 5 mass % relative to the total amount of the above-mentioned polymerizable monomer. When the amount of the chain transfer agent is within this range, there may be obtained efficiently a thermoplastic resin with high polymerization reaction rate and capable of post-cross-linking.

The polymerizable composition for hard resin layer usually contains a cross-linking agent to enable the cross-linking reaction after the bulk polymerization reaction.
As the cross-linking agent, for example, radical generator, epoxy compound, isocyanate group containing compound, carboxyl group containing compound, acid anhydride group containing compound, amino group containing compound, Lewis acid, etc. may be mentioned. These may be used either alone or in combination of two or more kinds. Among them, using of radical generator, epoxy compound, isocyanate group containing compound, carboxyl group containing compound, and acid anhydride group containing compound is preferred, radical generator, epoxy compound, and isocyanate group containing compound is more preferred, using of radical generator is particularly preferred.

As the radical generator include organic peroxide, diazo compound, nonpolar radical generator, etc. may be mentioned.
As the organic peroxide, for example, t-buthyl hydroperoxide, p-menthane hydroperoxide, cumene hydroperoxide, and other hydroperoxides; dicumyl peroxide, t-butylcumyl peroxide, α,α'-bis(t-butylperoxy-m-isopropyl)benzene, di-t-butyl peroxide, 2,5-dimethyl-2,5-di(t-butylperoxy)-3-hexine, 2,5-dimethyl-2,5-di(t-butylperoxy)hexane, and other dialkyl peroxides; dipropionyl peroxide, benzoyl peroxide, and other diacyl peroxides; 2,2-di(t-butylperoxy)butane, 1,1-di(t-hexylperoxy)cyclohexane, 1,1-di(t-butylperoxy)-2-methylcyclohexane, 1,1-di(t-butylperoxy)cycohexane, and other peroxy ketals; t-butyl peroxyacetate, t-butyl peroxybenzoate, and other peroxyesters; t-butylperoxy isopropyl carbonate, di(isopropylperoxy)dicarbonate, and other peroxycarbonates; t-butyl trimethylsilyl peroxide, and other alkylsilyl peroxides; etc. may be mentioned. Among them, dialkyl peroxides and proxy ketals are preferred because of little interferences to the metathesis polymerization reaction.

As the diazo compound, for example, 4,4'-bisazidebenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenylsulfone, 4,4'-diazidodiphenylmethane, and 2,2'-diazidostilbene, etc. may be mentioned.

As the nonpolar radical generator used in the present invention, 2,3-dimethyl-2,3-diphenyl butane, 2,3-diphenyl butane, 1,4-diphenyl butane, 3,4-dimethyl-3,4-diphenyl hexane, 1,1,2,2-tetraphenyl ethane, 2,2,3,3-tetraphenyl butane, 3,3,4,4-tetraphenyl hexane, 1,1,2-triphenyl propane, 1,1,2-triphenyl ethane, triphenyl methane, 1,1,1-triphenyl ethane, 1,1,1-triphenyl propane, 1,1,1-triphenyl butane, 1,1,1-triphenyl pentane, 1,1,1-triphenyl-2-propene, 1,1,1-triphenyl-4-pentene, 1,1,1-triphenyl-2-phenylethane, etc. may be mentioned.

These radical generators may be used either alone or in combination of two or more kinds. By using two or more kinds of the radical generators in combination and varying the blend ratio thereof, it is possible to arbitrarily control the glass transition temperature and the molten state of crosslinkable polymers and cross-linked articles to be obtained. The crosslinking agent used for the hard resin layer preferably has a one-minute half-life temperature lower than or equal to 180°C, and more preferably lower than or equal to 170°C.

These radical generators include what behaves as the above-mentioned polymerization catalyst. When acrylate compounds or styrenes are used as the polymerizable monomer, preferred are using two or more kinds of radical generators with different one-minute half-life temperatures, performing a bulk polymerization at a temperature where only a part of radical generators selectively decomposes, and then performing a cross-linking reaction at a relatively higher temperature where the rest of radical generators decompose. Alternatively, when only one kind of radical generator is used, by stopping the polymerization reaction in midstream and allowing a part of the radical generator to remain in a crosslinkable resin to be obtained, it is possible to use the remaining radical generator as the cross-linking agent.

The amount of the cross-linking agent is usually 0.1 to 10 parts by mass, and preferably 0.5 to 5 parts by mass relative to 100 parts by mass of the polymerizable monomer. If the amount of the cross-linking agent is too little, the cross-linkage may be insufficient, and a cross-linked product with high cross-linking density may not be obtained. To the contrary, if the amount of the cross-linking agent is too large, while the cross-linking effect is saturated, polymers and cross-linked articles with desired properties may not be obtained.

In addition, in the case of using the radical generator as the cross-linking agent in the present invention, a cross-linking aid may be used for the purpose of accelerating the cross-linking reaction. As the cross-linking aid, p-quinone dioxime, and other dioxime compounds; lauryl methacrylate, trimethylolpropane trimethacrylate, and other methacrylate compounds; diallyl fumarate, and other fumaric acid compounds; diallyl phthalate, and other phthalic acid compounds; triallyl cyanurate, and other cyanuric acid compounds; maleimide, and other imide compounds; etc. may be mentioned. Although the amount of the cross-linking aid is not particularly limited, it is usually 0 to 100 parts by mass, and preferably 0 to 50 parts by mass relative to 100 parts by mass of the polymerizable monomer.

The above polymerizable composition for hard resin layer may contain various kinds of additives such as a polymerization reaction retarder, a radical cross-linking retarder, a modifier, an antioxidant, a flame retarder, a filler, a coloring agent, and a light stabilizer, for example. These may be used in a form of being dissolved or dispersed in a monomer liqud or a catalyst liquid to be described hereinafter in advance.

As the polymerization reaction retarder, triphenyl phosphine, tributyl phosphine, trimethyl phosphine, triethyl phosphine, dicyclohexyl phosphine, vinyldiphenyl phosphine, allyldiphenyl phosphine, triallyl phosphine, styryldiphenyl phosphine, and other phosphine compounds; aniline, pyridine, and other Lewis bases; may be mentioned.
Herein, among cyclic olefin based monomers copolymerizable with norbornene based monomers, a cyclic olefin having 1,5-diene structure or 1,3,5-triene structure therein acts as the polymerization reaction retarder. As the compound, 1,5-cyclooctadiene, 5-vinyl-2-norbornene, etc. may be mentioned.

Among such polymerization reaction retarders, phosphine compounds are preferred, triphenyl phosphine, triethyl phosphine, dicyclohexyl phosphine, and vinyldiphenyl phosphine are more preferred, because of having a significant effect of suppressing the polymerization reaction progressing below room temperature.

As the radical cross-linking retarder, alkoxyphenols, catechols and benzoquinones may be mentioned, 3,5-di-t-butyl-4-hydroxyanisole, and other alkoxyphenols are preferred.

As the modifier, natural rubber, styrene-butadiene copolymer (SBR), styrene-butadiene-styrene block copolymer (SBS), styrene-isoprene-styrene block copolymer (SIS), ethylene-propylene-diene-terpolymer (EPDM) and ethylene-vinyl acetate copolymer (EVA) and hydrogenation products thereof and other elastomers may be mentioned.

As the antioxidant, hindered phenol based, phosphorus based and amine based etc. of various kinds of antioxidants for plastics and rubbers may be mentioned. Although these antioxidants may be used either alone, preferred is being used in combination of two or more kinds.

As the flame retarder, phosphorus based flame retarders, nitrogen based flame retarders, halogen based flame retarders, aluminum hydroxide or other metal hydroxide based flame retarders, antimony trioxide, and other antimony compounds, etc. may be mentioned. Although the flame retarders may be used either alone, preferred is being used in combination of two or more kinds.

As the filler, glass powder, ceramic powder, silica, etc. may be mentioned. In addition, chopped strand, milled fiber, and other short-fiber-like fillers may be also used. As such fibers, glass fiber, carbon fiber, metal fiber, and other inorganic fibers; aramid fiber, nylon fiber, and other organic fibers; may be mentioned. These fillers may be also used in combination of two or more kinds. As the filler, surface treated fillers by silane coupling agents etc. may be also used. The amount of the fillers is usually 0 to 600 parts by mass, preferably 50 to 500 parts by mass, and more preferably 50 to 300 parts by mass relative to 100 parts by mass of the polymerizable monomer.

As the coloring agent, dye stuff, pigment etc. may be used. There are various kinds of dye stuffs and known in the art may be appropriately chosen and used.

The polymerizable composition for hard resin layer is preferably prepared through the following steps: (I) obtaining a catalyst liquid by dissolving or dispersing the polymerization initiator into a solvent, while preparing a monomer liquid by adding additives such as filler and flame retarder if needed to the polymerizable monomer; and (II) adding the catalyst liquid to the monomer liquid and stirring and mixing them.

Preferred is to perform the mixing of the catalyst liquid and the monomer liquid just before the polymerization. In addition, the chain transfer agent, the cross-linking agent and the like to be added if needed may be added to the monomer liquid and/or the catalyst liquid before mixing the monomer liquid and the catalyst liquid, or alternatively may be added to the mixed liquid after mixing the monomer liquid and the catalyst liquid. The mixing of the catalyst liquid and the monomer liquid is preferably performed at a temperature in a range of 0°C to 25°C. If the temperature of the mixing is too low, the viscosity of the monomer liquid becomes high, and as a result it becomes difficult to mix the catalyst liquid homogeneously thereto. If the temperature of the mixing is too high, the polymerization reaction is liable to progress rapidly.

The hard resin layer may be obtained by applying the above mentioned polymerizable composition for hard resin layer onto the above mentioned metal foil to obtain a coated film of the composition, and applying heat to the coated film thereby subjecting the polymerizable composition for hard resin layer to the bulk polymerization reaction and the cross-linking reaction. Alternatively, the hard resin layer may be also obtained by impregnating the polymerizable composition for hard resin layer into a fibrous material such as nonwoven fabric, overlapping the impregnated material onto the metal foil, and heating thereby subjecting the polymerizable composition for hard resin layer to the bulk polymerization reaction and the cross-linking reaction.

Although the method of applying the polymerizable composition for hard resin layer onto the metal foil is not particularly restricted, spray coat method, dip coat method, roll coat method, curtain coat method, dye coat method, slit coat method, and other methods known in the art may be mentioned.

Fibrous material to which the polymerizable composition for hard resin layer is impregnatable may be arbitrarily selected from organic fibers and/or inorganic fibers. For example, fibrous materials formed from glass fiber, carbon fiber, aramid fiber, polyethylene terephthalate fiber, vinylon fiber, polyester fiber, amide fiber, metal fiber, ceramic fiber, etc. may be mentioned. These may be used either alone or in combination of two or more kinds. As the form of the fibrous material, mat, cross, nonwoven, etc. may be mentioned. In addition, these fibrous materials are preferably surface treated by using silane coupling agent.

Impregnation of the polymerizable composition for hard resin layer into the fibrous material may be performed by, for example, applying a predetermined amount of the polymerizable composition for hard resin layer onto the fibrous material by a method known in the art such as spray coat method, dip coat method, roll coat method, curtain coat method, dye coat method or slit coat method, overlapping a protection film thereon if necessary, and applying a pressure force thereon from the upper side by using a roller or the like.

The polymerizable composition for hard resin layer polymerizes slowly below room temperature and the increasing of the viscosity thereof is suppressed, and therefore it is possible to be impregnated homogeneously into the fibrous material. The polymerizable composition for hard resin layer may be subjected to bulk polymerization after being impregnated into the fibrous material and by heating the impregnated material to a predetermined temperature, and thereby a prepreg in which the polymer is impregnated into the fibrous material is obtained.

The heating temperature for polymerizing the polymerizable composition for hard resin layer is preferably 80°C or higher, and more preferably 100°C to 200°C. The polymerization time may be selected appropriately, and 10 seconds to 20 minutes in usual, and preferably within 5 minutes. A peak temperature of the bulk polymerization reaction is preferably set to be lower than or equal to the one-minute half-life temperature of the above-mentioned radical generator in order to completely progress the bulk polymerization reaction alone and not to progress the cross-linking reaction. The peak temperature may be controlled to be in usual 230°C or lower, and preferably 200°C or lower. The temperature of the polymerizable composition in the polymerization reaction may be measured by using a noncontact thermometer, for example.

A method of heating the polymerizable composition for hard resin layer to a predetermined temperature is not particularly limited, a method of placing on a heat plate and heating, a method of using a pressing machine for heating while pressurizing (heat pressing), a method of applying a pressing force with a heated roller, a method of using a heating furnace, etc. may be mentioned. The bulk polymer obtained by the heat pressing or using the roller has a thickness being usually 1 mm or thinner, preferably 0.5 mm or thinner, more preferably 0.2 mm or thinner.

The cross-linking reaction may be performed by maintaining the bulk polymer at a temperature equal to or higher than a temperature causing the polymer to cross-linking react, for example by heating and melting the bulk polymer. A temperature at the time of cross-linking the polymer is preferably higher than the above-mentioned peak temperature at the time of the bulk polymerization by 20°C or more. The temperature at the time of cross-linking the polymer is usually in a range of 170°C to 250°C, and preferably 180°C to 220°C. In addition, although the time for the cross-linking is not particularly limited, the time is usually in a range of several minutes to several hours. The cross-linking reaction is preferably performed by the heat pressing method. A pressure at the time of the heat pressing is usually 0.5 to 20 MPa, and preferably 3 to 10 MPa. The heat pressing may be also performed in vacuum or reduced atmosphere. The heat pressing may be performed by using a known pressing machine having a press frame for plate-shape forming, or a press forming machine for a sheet mold compound (SMC), bulk mold compound (BMC), or the like.

In the hard resin layer, the above-mentioned polymerizable composition for hard resin layer is almost totally subjected to the bulk polymerization reaction and further to the cross-linking reaction, and accordingly there remains scarcely residual monomer thereby to prevent worsening of work environment caused from odor and the like. Moreover, the bulk polymer moderately flows at the time of the cross-linking reaction to fill microscopic concavities and convexities of the metal foil, thereby an adhesion property between the hard resin layer and the metal foil is good.
The thickness of the hard resin layer is, relative to a total thickness of the adhesive resin layer to be described hereinafter and the hard resin layer, usually 10% or more, preferably 25% or more, more preferably 50% or more, and furthermore preferably 700 or more. Herein, the upper limit thereof is usually 99.9%, and preferably 99%.

### (Adhesive resin layer)

The adhesive resin layer is obtained by subjecting a polymerizable composition (hereinafter referred to as "polymerizable composition for adhesive resin layer") as a precursor thereof to a bulk polymerization reaction. The adhesive resin layer is a layer soluble within 30 seconds when the layer is immersed in a solvent capable of dissolving an adhesive resin, because a resin forming the adhesive resin layer has not substantially cross-linked. In addition, it is preferred that the adhesive resin layer is hardly to be deteriorated at the time of being immerse in an etching liquid such as ferric chloride water solution or the like or in a desmear liquid.

A weight-average molecular weight of the adhesive resin forming the adhesive resin layer is usually 5,000 to 80,000, preferably 10,000 to 50,000, and more preferably 15,000 to 30,000.

The polymerizable composition for adhesive resin layer is not particularly limited so long as being polymerizable. For example, the polymerizable composition for adhesive resin layer contains a polymerizable monomer and a polymerization generator. The polymerizable composition for adhesive resin layer may be the same as the above-mentioned polymerizable composition for hard resin layer, or alternatively be a composition obtained by removing the cross-linking agent from the polymerizable composition for hard resin layer. In order to form the adhesive resin layer by using the same as the above-mentioned polymerizable composition for hard resin layer, preferred is to be subjected to the bulk polymerization at a temperature hardly to progress the cross-linking reaction.
The cross-linking agent used for the adhesive resin layer preferably has a one-minute half-life temperature higher than or equal to 180°C, and more preferably higher than or equal to 190°C.

The adhesive resin layer is preferably soluble in solvents such as benzene, toluene, and other aromatic hydrocarbons, diethyl ether, tetrahydrofuran, and other ethers, dichloromethane, chloroform, and other halogenated hydrocarbons. In addition, the adhesive resin layer preferably has a thermoplasticity so as to be capable of deforming in accordance with concavities and convexities of a circuit board.

The thickness of the adhesive resin layer is appropriately selected depending on the thickness of a conductive circuit of the circuit board, and preferably is possibly thin so long as the adhesive resin layer can be embedded onto the conductive circuit. If the adhesive resin layer is too thick, the adhesive resin layer may deform at the time of forming via holes. The thickness of the adhesive resin layer is usually 0.1 to 100 µm, preferably 1 to 50 µm, and more preferably 2 to 30 µm.

The adhesive resin layer may be obtained by, applying the polymerizable composition for adhesive resin layer onto the above-mentioned hard resin layer (or the crosslinkable resin layer as a precursor of the hard resin) to obtain a coated film of the composition and applying heat to the coated film thereby subjecting the polymerizable composition for adhesive resin layer to the bulk polymerization reaction, or impregnating the polymerizable composition for adhesive resin layer into nonwoven fabric and other fibrous materials, overlapping the impregnated material onto the above-mentioned hard resin layer (or the crosslinkable resin layer as a precursor of the hard resin) and heating thereby subjecting the polymerizable composition for adhesive resin layer to the bulk polymerization reaction.
Alternatively, the adhesive resin layer may be obtained at the same time as obtaining the hard resin layer or the crosslinkable resin layer by using a single polymerizable composition to act as both the polymerizable composition for hard resin layer and the polymerizable composition for adhesive resin layer.

### (Manufacturing method of composite for multilayer circuit board)

(1) One preferred embodiment of the manufacturing method of composite for multilayer circuit board according to the present invention includes, forming an intermediate composite (A) by integrating a layer of metal foil and a crosslinkable resin layer containing a resin obtained by bulk polymerization reaction and a cross-linking agent, and applying heat to the intermediate composite (A) from the metal foil layer side such that cross-linking reaction occurs in a limited region of the crosslinkable resin layer adjacent to the metal foil thereby the crosslinkable resin layer becomes to comprise a hard resin layer and an adhesive resin layer.
That is, the manufacturing method includes forming firstly the crosslinkable resin layer which is expected to form the hard resin layer and the adhesive resin layer, and then forming the hard resin layer and the adhesive resin layer at the same time by subjecting to cross-linking reaction only a limited region of the crosslinkable resin layer adjacent to the metal foil.

Specific process for this manufacturing method is, for example, as follows. (i) A crosslinkable and polymerizable composition containing a bulk polymerizable monomer and the cross-linking agent is applied onto the metal foil thereby to form a coated film of the crosslinkable and polymerizable composition. Next, by applying heat to the obtained coated film, the whole of the coated film of the crosslinkable and polymerizable composition is bulk polymerized. Then, the hard resin layer and the adhesive resin layer are obtained at the same time by applying heat to the bulk polymerized coated film (crosslinkable resin layer) from the metal foil side and subjecting a limited region of the coated film near the metal foil in the thickness direction thereof to a cross-linking reaction. It is to be noted that, in the manufacturing method according to (i), the surface of the coated film far from the metal foil may be cooled if needed at the time of applying heat to the bulk polymerized coated film from the metal foil side. Herein, in the manufacturing method according to (i), the crosslinkable and polymerizable composition acts as both the polymerizable composition for hard resin layer and the polymerizable composition for adhesive resin layer.
Arternatively, another specific process for the manufacturing method is, for example, as follows. (ii) A crosslinkable and polymerizable composition containing a bulk polymerizable monomer and the cross-linking agent is impregnated into nonwoven fabric and other fibrous materials, and the impregnated material is overlapped onto the metal foil. Next, by applying heat to a laminated body which comprises the impregnated material and the metal foil and subjecting the crosslinkable and polymerizable composition to a bulk polymerization reaction, there is obtained a prepreg with the metal foil. The, the hard resin layer and the adhesive resin layer are obtained at the same time by applying heat to the prepreg (crosslinkable resin layer) from the metal foil side and subjecting a limited region of the prepreg near the metal foil in the thickness direction thereof to a cross-linking reaction. It is to be noted that, in the manufacturing method according to (ii), the surface of the prepreg far from the metal foil may be cooled if needed at the time of applying heat to the prepreg from the metal foil side. Herein, in the manufacturing method according to (ii), the crosslinkable and polymerizable composition acts as both the polymerizable composition for hard resin layer and the polymerizable composition for adhesive resin layer.

In the method according to (i) or (ii), the heating temperature of the limited region (near side to the metal foil) required to be subjected to the cross-linking reaction at the time of applying heat from the metal foil layer side is usually 210°C or higher, preferably 220°C or higher, more preferably 230°C or higher, furthermore preferably 240°C or higher, most preferably 250°C or higher. The temperature of a region (far side from the metal foil) required not to be subjected to the cross-linking reaction at the time of applying heat from the layer of metal foil side is usually the one-minute half-life temperature of the cross-linking agent contained in the crosslinkable and polymerizable composition or lower, preferably 100°C or lower, more preferably 60°C or or lower, furthermore preferably 40°C or lower, still furthermore preferably room temperature or lower, most preferably 10°C or lower.

The region to be cross-linked within the crosslinkable resin layer may be usually enough so long as being slightly present in the thickness direction thereof, and preferably 250 or more, more preferably 500 or more, furthermore preferably 75% or more.

Regarding the composite obtained through the method of (i) or (ii) in accordance with the present invention, the adhesive resin layer is cross-linked by heating the adhesive resin layer side of the composite to the temperature where the cross-linking reaction starts, at the time of laminating and bonding the composite to a circuit board, thereby enabling to provide a multilayer circuit board having good adhesion properties.

(2) Another preferred embodiment of the manufacturing method of composite for multilayer circuit board according to the present invention includes, forming an intermediate composite (B) by arranging a metal foil layer, a crosslinkable resin layer containing a resin obtained by bulk polymerization reaction and a cross-linking agent (α), and an adhesive resin layer in this order to be integrated to each other, and heating the intermediate composite (B) to cross-link at least in part of the resin contained in the crosslinkable resin layer such that the crosslinkable resin layer becomes to be a hard resin layer.
Specific process for this manufacturing method is, for example, as follows. (iii) A multilayer coated film is formed by applying, as a precursor of the hard resin layer, a crosslinkable and polymerizable composition (a) containing a bulk polymerizable monomer and a cross-linking agent (α) and, as a precursor of the adhesive resin layer, a polymerizable composition (b) containing a bulk polymerizable monomer but not containing a cross-linking agent onto the metal foil in this order. Next, by heating the multilayer coated film and subjecting the crosslinkable and polymerizable composition (a) and the polymerizable composition (b) to the bulk polymerization reaction, these compositions (a) and (b) becomes to be the crosslinkable resin layer and the adhesive resin layer, respectively, and thereby the intermediate composite (B) is obtained. Then, by heating the intermediate composite (B) to cross-link the crosslinkable resin layer, the crosslinkable resin layer may become to be the hard resin layer. It is to be noted that, in the manufacturing method according to (iii), the hard resin layer and the adhesive resin layer may be obtained simultaneously at the time of heating the multilayer coated film comprising the crosslinkable and polymerizable composition (a) and the polymerizable composition (b), by subjecting the crosslinkable and polymerizable composition (a) to the cross-linking reaction in addition to the bulk polymerization reaction and subjecting the polymerizable composition (b) to the bulk polymerization reaction. In this regard, the composite for multilayer circuit board is manufactured without passing through the intermediate composite (B). It is to be additionally noted that, in the manufacturing method according to (iii), the crosslinkable and polymerizable composition (a) corresponds to the polymerizable composition for hard resin layer, and the polymerizable composition (b) corresponds to the polymerizable composition for adhesive resin layer.

Arternatively, another specific process for the manufacturing method is, for Example, as follows. (iv) As a precursor of the hard resin layer, a crosslinkable and polymerizable composition (a) containing a bulk polymerizable monomer and a cross-linking agent (α) is impregnated into nonwoven fabric and other fibrous materials from one surface thereof, as a precursor of the adhesive resin layer, a polymerizable composition (b) containing a bulk polymerizable monomer but not containing a cross-linking agent is impregnated into the fibrous material from the other surface thereof, and a laminated body is obtained by overlapping the impregnated material onto the metal foil. Next, by applying heat to the laminated body and subjecting the crosslinkable and polymerizable composition (a) and the polymerizable composition (b) to the bulk polymerization reaction, these compositions (a) and (b) becomes to be the crosslinkable resin layer and the adhesive resin layer, respectively, and thereby the intermediate composite (B) is obtained. Then, by heating the intermediate composite (B) to cross-link the crosslinkable resin layer, the crosslinkable resin layer may become to be the hard resin layer. It is to be noted that, in the manufacturing method according to (iv), the hard resin layer and the adhesive resin layer may be obtained simultaneously at the time of heating the multilayer coated film comprising the crosslinkable and polymerizable composition (a) and the polymerizable composition (b), by subjecting the crosslinkable and polymerizable composition (a) to the cross-linking reaction in addition to the bulk polymerization reaction and subjecting the polymerizable composition (b) to the bulk polymerization reaction. In this regard, the composite for multilayer circuit board is manufactured without passing through the intermediate composite (B). It is to be additionally noted that, in the manufacturing method according to (iv), the crosslinkable and polymerizable composition (a) corresponds to the polymerizable composition for hard resin layer, and the polymerizable composition (b) corresponds to the polymerizable composition for adhesive resin layer.

In the method according to (iii) or (iv), because the crosslinkable and polymerizable composition (a) and the polymerizable composition (b) is to be bulk polymerized, it is unnecessary to provide a process of removing a solvent after applying the polymerizable composition (b) onto the metal foil or impregnating the same into the fibrous material, and therefore the productivity is superior. Moreover, because the polymerizable composition (b) does not contain a solvent, it is suppressed that crosslinkable and polymerizable composition (a) and the polymerizable composition (b) are mixed together at the time of applying the polymerizable composition (b) onto the crosslinkable and polymerizable composition (a) or impregnating the same into the fibrous material, and therefore the composite according to the present invention can be obtained efficiently.

(3) As a still another preferred embodiment of the manufacturing method of composite for multilayer circuit board according to the present invention, in the method according to (iii) or (iv), the polymerizable composition (b) expected to be the adhesive resin layer preferably further contains a cross-linking agent (β) with one-minute half-life temperature higher than that of the cross-linking agent (α). Specific process for the manufacturing method of composite for multilayer circuit board in the case that the polymerizable composition (b) contains the cross-linking agent (β) is, for Example, as follows. (v) A multilayer coated film is formed by applying, as a precursor of the hard resin layer, a crosslinkable and polymerizable composition (a) containing a bulk polymerizable monomer and a cross-linking agent (α) for starting cross-linking at a lower temperature and, as a precursor of the adhesive resin layer, a cross-linking-capable polymerizable composition (b) containing a bulk polymerizable monomer and a cross-linking agent (β) for starting cross-linking at a higher temperature onto the metal foil in this order. Next, by heating the multilayer coated film to a temperature where the cross-linking agent (α) starts to act and subjecting the crosslinkable and polymerizable composition (a) to the bulk polymerization reaction and the cross-linking reaction , and subjecting the cross-linking-capable polymerizable composition (b) to the bulk polymerization reaction, the crosslinkable resin layer may become to be the hard resin layer. It is to be noted that, in the manufacturing method according to (v), the crosslinkable and polymerizable composition (a) corresponds to the polymerizable composition for hard resin layer, and the cross-linking-capable polymerizable composition (b) corresponds to the polymerizable composition for adhesive resin layer.

Arternatively, another specific process for the manufacturing method of composite for multilayer circuit board in the case that the polymerizable composition (b) contains the cross-linking agent (β) is, for example, as follows. (vi) As a precursor of the hard resin layer, a crosslinkable and polymerizable composition (a) containing a bulk polymerizable monomer and a cross-linking agent (α) starting cross-linking reaction at a lower temperature is impregnated into nonwoven fabric and other fibrous materials from one surface thereof, as a precursor of the adhesive resin layer, a cross-linking-capable polymerizable composition (b) containing a bulk polymerizable monomer and a cross-linking agent (β) starting cross-linking at a higher temperature is impregnated into the fibrous material from the other surface thereof, and a laminated body is obtained by overlapping the impregnated material onto the metal foil. Next, by heating the laminated body to a temperature where the cross-linking agent (α) starts to act and subjecting the crosslinkable and polymerizable composition (a) to the bulk polymerization reaction and the cross-linking reaction, and subjecting the cross-linking-capable polymerizable composition (b) to the bulk polymerization reaction, the crosslinkable resin layer may become to be the hard resin layer. It is to be noted that, in the manufacturing method according to (vi), the crosslinkable and polymerizable composition (a) corresponds to the polymerizable composition for hard resin layer, and the cross-linking-capable polymerizable composition (b) corresponds to the polymerizable composition for adhesive resin layer.
According to the method of (v) or (vi) wherein the polymerizable composition (b) contains the cross-linking agent (β), the adhesive resin layer is cross-linked by being heated to the temperature where the cross-linking agent (β) starts to act, at the time of laminating and bonding the composite for multilayer circuit board according to the present invention to a circuit board, thereby enabling to provide a multilayer circuit board having good adhesion properties.

(4) Yet another preferred embodiment of the manufacturing method of composite for multilayer circuit board according to the present invention includes, a first step of applying a crosslinkable and polymerizable composition (a) containing a bulk polymerizable monomer and a cross-linking agent (α) on a metal foil and then forming a crosslinkable resin layer through a bulk polymerization reaction, a second step of cross-linking at least in part of the crosslinkable resin layer to form a hard resin layer, and a third step of applying a polymerizable composition (b) containing a bulk polymerizable monomer onto the hard resin layer and then forming an adhesive resin layer through a bulk polymerization reaction. The polymerizable composition (b) preferably further contains a cross-linking agent (β) with one-minute half-life temperature higher than that of the cross-linking agent (α). It is to be noted that, in this manufacturing method, the crosslinkable and polymerizable composition (a) corresponds to the polymerizable composition for hard resin layer, and the polymerizable composition (b) corresponds to the polymerizable composition for adhesive resin layer.
In this manufacturing method, the first step of forming the crosslinkable resin layer, the second step of forming the hard resin layer and the third step of forming the adhesive resin layer may be performed in this order, or alternatively the first step of forming the crosslinkable resin layer, the third step of forming the adhesive resin layer and the second step of forming the hard resin layer may be performed in this order. According to this manufacturing method, because the polymerizable composition (b) is to be bulk polymerized and does not contain a solvent, it is suppressed that the crosslinkable resin layer or the hard resin layer dissolves into the polymerizable composition (b) at the time of applying the polymerizable composition (b) onto the the crosslinkable resin layer or the hard resin layer, and therefore the composite according to the present invention can be obtained efficiently.

It is to be noted that, in the manufacturing method of composite for multilayer circuit board according to the present invention, handlings such as heating, applying and impregnating may be performed similarly to those exemplified for the hard resin layer.

In the composite according to the present invention, it is not necessary that a definitive boundary exists between the adhesive resin layer and the hard resin layer, and rather the composite may be a composite in which the hard resin layer gradually changes to the adhesive resin layer, for example. In the composite obtained according to the method of (i) or (ii), because temperatures at the time of the cross-linking are distributed in the thickness direction thereof, the cross-linking reaction varies in degree from the near side to the far side with respect to the metal foil. In this case, the vicinity of the metal foil is the hard resin layer in which the cross-linking has highly progressed and the far side from the metal foil is the adhesive resin layer in which the cross-linking has not progressed, and the composite therebetween is a composite in which the hard resin layer gradually changes to the adhesive resin layer.

The composite for multilayer circuit board according to the present invention enables to easily obtain a multilayer circuit board by using the same.
Specifically, a conductive circuit is firstly formed by patterning the metal foil layer of the composite for multilayer circuit board according to the present invention. The method for patterning the metal foil is not particularly restricted, photolithographic method, laser processing method, etc. may be mentioned.

Next, via holes are formed to penetrate through the hard resin layer and the adhesive resin layer and to make the above-mentioned conductive layer exposed at the bottom surface side of the via hole. Then, a single sided circuit board for multilayer circuit board is obtained by giving a conductor into the via hole to provide a wiring electrically conducted from the conductive circuit to the adhesive resin layer side.
Forming method relevant to the via hole is not particularly restricted, and laser perforating method, paste printing method, etc. may be mentioned. In order to remove laser smears arising from the laser perforating method after forming the via hole, a permanganic acid desmearing method may be performed.

In addition, the method of giving the conductor into the via hole is not particularly restricted, and screen printing method for filling the via hole with conductive paste may be mentioned. After removing a protection film used in the screen printing method, there is formed a conductive bump by projecting conductive paste from the surface of the adhesive resin layer. The height of the conductive bump is usually 5 to 100 µm. It is to be noted that, alternatively to filling with the conductive paste, the conductor may be given into the via hole by plating.

By overlapping two or more of the above-mentioned single sided circuit boards for multilayer circuit board or overlapping the single sided circuit boards for multilayer circuit board onto other circuit board, followed by heat pressing to laminate, there is obtained a multilayer circuit board having an internal wiring and a surface wiring. Particularly according to the present invention, the adhesive resin layer melts by heat pressing thereby to deform in accordance with concavities and convexities of a circuit board. In the case of the adhesive resin layer containing the cross-linking agent, the cross-linking reaction progresses with further heating, and adhesion property is improved.

### EXAMPLES

Although the present invention will be described hereinafter with reference to examples and comparative examples, the present invention is not limited to these examples. It is to be noted that, hereinafter, "parts" and "%" are based on mass basis unless otherwise noted.

### Lamination properties (Scrape)

Scrape was evaluated with the following criteria after visually observing a multilayer circuit board.
A: There is no scrape relative to the total area and the board is even.
B: There is a scrape more than 0% and less than 10% relative to the total area.
C: There is a scrape more than or equal to 10% and less than 30% relative to the total area.
D: There is a scrape more than or equal to 30% relative to the total area.
Herein, the word "scrape" is intended to mean that an empty space takes place between different materials, such as a copper foil and a resin, a resin and a glass cloth, and a resin and an IPC board. The less the scrape, the cross-linking resin composite becomes more even with or without wiring patterns thereby showing superior in shape forming capability.

### Lamination properties (Displacement)

Figures 1 illustrate an exemplary method of obtaining a displacement. Figure 1(a) is a view illustrating composites each having an adhesive resin layer (not-cross-linked resin layer) 23, and a pattern-like wiring 21 formed on a hard resin layer (cross-linked resin layer) 22, in a state where the center lines of the wirings 21 are exactly aligned to each other and the n sheets of composites are overlapped together. When this overlapped body is pressed, an outer layer (the first layer or the n-th layer) is fixed in the position thereof by a press plate, whereas an inner layer (the second layer, the third layer, ···, the (n-2)th layer, or the (n-1)th layer, for example) may be displaced to the left or the right in a certain degree, as shown in figure 1(b) which illustrates after-pressed-state (multilayer circuit board). Herein, the third layer to the (n-2)th layer are omitted to be illustrated in figures 1(a) and 1(b). In addition, A indicates a wiring width in figure 1(b), and the center line of each wiring 21 of the outer layers is indicated by a one-dot chain line and the center line of each wiring 21 of the second layer and the (n-1)th layer is illustrated by a two-dot chain line in figure 1(b). In the exemplar illustrated in figure 1(b), the second layer is displaced to the left, the (n-1)th layer is displaced to the right, and the displacement of the (n-1)th layer is largest, and therefore B (the distance between the center line of the wiring 21 of the outer layer and the center line of the wiring 21 of the (n-1)th layer) is the maximum displacement.
Thus, after measuring the maximum displacement B of the multilayer circuit board between the center line of the wiring of the outer layer (one-dot chain line) and the center line of the wiring of the other layer (two-dot chain line), the ratio of the maximum displacement B relative to the wiring width A (= (B/A)x100 [%]) was obtained and evaluated with the following criteria.
A: less than 10%
B: more than or equal to 10% and less than 30%
C: more than or equal to 30% and less than 50%
D: more than or equal to 50%

### Peel strength

A 12 µm SLP copper foil laminated on a composite is peeled from the composit based on JIS C6481, and the strength at the time was measured. The peel strength was evaluated with following criteria in accordance with values thereof.
A: higher than 0.7 kN/m
B: higher than 0.6 kN/m and lower than or equal to 0.7 kN/m
C: higher than 0.4 kN/m and lower than or equal to 0.6 kN/m
D: higher than 0.1 kN/m and lower than or equal to 0.4 kN/m
Herein, a peel strength between the copper foil and the hard resin layer before heat pressing a single composite and a peel strength between the copper foil and the hard resin layer after heat pressing a plurality of composites were measured.

### Electrical property (Dielectric loss (tanδ))

Dielectric loss (tanδ) at the frequency of 1 GHz was measured by a capacitance method using an impedance analyzer (product number E4991 available from Agilent Technologies, Inc). The dielectric loss was evaluated with the following criteria in accordance with values thereof.
A: smaller than or equal to 0.0015
B: larger than 0.0015 and smaller than or equal to 0.0020
C: larger than 0.0020

### Reliability (Soldering test)

After cutting out a multilayer circuit board into a piece with 1 cm width and 5 cm length, the piece was immersed into a solder bath of 260°C during 10 seconds and then the piece was pulled up from the bath. Surface appearances of both faces of the piece were observed and evaluated with the following criteria after repeating three times the immersion and the pulling up.
A: no blister occurring
B: blister occurring within an area smaller than 10% by area
C: blister occurring within an area larger than or equal to 10% by area and smaller than 30% by area
D: blister occurring within an area larger than or equal to 30% by area

### (Example 1)

Benzylidene(1,3-dimesityl imidazolidine-2-ylidene)(tricyclohexyl phosphine)ruthenium dichloride in 0.1 part and triphenyl phosphine in 0.2 part were put into a flask. Under a nitrogen atmosphere, toluene in 2.4 parts was poured into the flask for dissolution to prepare a catalyst liquid.

To a mixture of tetracyclo[6.2.1.1^{3,6}.0^{2,7}]dodeca-4-ene in 80 parts and norbornene in 20 parts, silica (product name SO-E1 made by Admatechs Company Limited, silane coupling agent treated product; average particle diameter of 0.2 µm) as a filler in 80 parts was added, and the mixture was stirred to be homogeneous. To the mixture, hexenyl methacrylate (Economer ML C5-type, made by Shin-Nakamura Chemical Co., Ltd.) as a chain transfer agent in 1 part and 2,2-di-t-butylperoxybutane (product name trigonox DT-50 made by Kayaku Akzo Corporation, one-minute half-life temperature of 161°C) as a cross-linking agent in 1 part were added, furthermore the above catalyst liquid in 0.35 part was added to the mixture and the mixture was stirred, and the crosslinkable and polymerizable composition (A) for the hard resin layer was obtained.

On the other hand, to a mixture of tetracyclo[6.2.1.1^{3,6}.0^{2,7}]dodeca-4-ene in 80 parts and norbornene in 20 parts, silica (product name SO-E1 made by Admatechs Company Limited, silane coupling agent treated product; average particle diameter of 0.2 µm) as a filler in 80 parts was added, and the mixture was stirred to be homogeneous. To the mixture, hexenyl methacrylate (Economer ML C5-type, made by Shin-Nakamura Chemical Co., Ltd.) as a chain transfer agent in 1.8 parts and di-t-butylperoxide (product name Kayabutyl D made by Kayaku Akzo Corporation, one-minute half-life temperature of 192°C) as a cross-linking agent in 1 part were added, furthermore the above catalyst liquid in 0.35 part was added to the mixture and the mixture was stirred, and the crosslinkable and polymerizable composition (B) for the adhesive resin layer was obtained.

A glass cloth (glass-made yarn cloth, product name GC2116, made by Asahi-Schwebel Co., Ltd.) was prepared, and one surface thereof was sprayed with the above crosslinkable and polymerizable composition (A) in 70 parts so as to be impregnated into the inside thereof. Furthermore, the other surface of the glass cloth was sprayed with the crosslinkable and polymerizable composition (B) in 30 parts so that the total thickness became to 100µm. In addition, an electrolytic copper foil (Type F0, thickness of 0.012 mm, made by Furukawa Circuit Foil Co., Ltd.) as a supporting body was laminated onto the crosslinkable and polymerizable composition (A) side, a polyethylene naphthalate (PEN) film (made by Teijin DuPont Films Limited, thickness of 75 µm) was laminated onto the crosslinkable and polymerizable composition (B) side, and the laminated body was heated at 130°C during one minute in an inert oven. The crosslinkable and polymerizable composition (A) and the crosslinkable and polymerizable composition (B) were bulk polymerized through the heating, and a film material with 4-layer structure (copper foil / not-cross-linked resin (A) / not-cross-linked resin (B) / PEN) was obtained.

This film material was subjected to passing through a pair of rolls consisting of a heating roll of 250°C to be contacted with the copper foil side and a cooling roll of 25°C to be contacted with the PEN side, and only the copper foil side was heated during one second. Through the heating, only the resin located at the copper foil side was cross-linked. After being returned to room temperature and peeling the PEN film, a composite with 3-layer structure of copper foil / cross-linked resin (hard resin layer) / not-cross-linked resin (adhesive resin layer) was obtained.

When the composite was immerse in toluene, the portion of the adhesive resin layer was dissolved but the portion of the hard resin layer was not dissolved, and the hard resin layer and the glass cloth were held to be adhered to the copper foil.
In addition, the adhesive resin layer face of the composite and a glass epoxy board FR-4 of 0.8 mm thickness were bonded to each other by using a double stick tape. Peel strength between the copper foil and the hard resin layer was measured to be 0.65 kN/m.

Next, five sheets of composites each obtained by removing completely the copper foil from the above composite using aqueous ferric chloride were prepared. The five sheets were laminated together, furthermore another composite without removing the copper foil was laminated thereon, the same was heat pressed at 200°C under the pressure of 3 MPa during 30 minutes, and a laminated body having the copper foil as the outer layer thereof was obtained. Peel strength between the copper foil and the hard resin layer of the obtained laminated body was measured to be 0.65 kN/m. Before and after the heat pressing, there observed no change of the peel strength between the copper foil and the hard resin layer.

Then, the copper foil of the composite was etched to form a pattern with line & space (L/S) = 100/100µm. Eight sheets of the composites with the patterned copper foils were prepared and the sheets were overlapped together such that the center lines of the lines (wiring widths) be exactly aligned to each other. The overlapped eight sheets were heat pressed at 200°C under 3 MPa during 30 minutes, and a multilayer circuit board was obtained. Through the heat pressing, adhesive resin layers were cross-linked. The vertical section of the multilayer circuit board was observed by using an optical microscope, there confirmed no scrape and displacement.
The multilayer circuit board was subjected to the soldering test, and there confirmed no blister.
On the other hand, six sheets of composites each obtained by removing completely the copper foil from the composite using aqueous ferric chloride were overlapped together, and the overlapped six sheets were heat pressed at 200°C under 3 MPa during 30 minutes. The obtained laminated body was cut out into a test piece with 20 mm square size. The dielectric loss of the test piece was measured. Results thereof are shown in table 1.

**[Table 1]**

| | Solvent Solubility | | Peel strength | | Lamination properties | | Electrical property | Reliability |
|---|---|---|---|---|---|---|---|---|
| | Hard resin layer | Adhesive resin layer | Before heat pressing | After heat pressing | Scrape | Displacement | tan δ | Soldering test |
| Example 1 | Insoluble | Soluble | A | A | A | A | A | A |
| Example 2 | Insoluble | Soluble | B | B | A | B | B | A |
| Example 3 | Insoluble | Soluble | C | C | B | C | C | A |
| Example 4 | Insoluble | Soluble | B | B | A | A | C | A |
| Example 5 | Insoluble | Soluble | A | A | A | A | A | A |
| Example 6 | Insoluble | Soluble | A | A | A | A | B | A |
| Example 7 | Insoluble | Soluble | A | A | A | A | B | A |
| Comparative Example 1 | Soluble | Soluble | Not adhering of copper foil and incapable of laminating | | | | | |
| Comparative Example 2 | Insoluble | Insoluble | Not flowing of resin and incapable of shape forming | | | | | |
| Comparative Example 3 | Incapable of film forming | | | | | | | |

### (Example 2)

The crosslinkable and polymerizable composition (A) was obtained in the same manner as in Example 1 except for changing the amount of hexenyl methacrylate to 1.8 parts and using, as a filler, CaTiO₃ (silane coupling agent treated product, average particle diameter of 1.5 µm) in 150 parts substituted for silica in 80 parts. In addition, the crosslinkable and polymerizable composition (B) was obtained in the same manner as in Example 1 except for using, as a filler, CaTiO₃ (silane coupling agent treated product, average particle diameter of 1.5 µm) in 150 parts substituted for silica in 80 parts. Next, except for using such crosslinkable and polymerizable compositions, a film material with 4-layer structure was obtained in the same manner as in Example 1. A composite with 3-layer structure was obtained in the same manner as in Example 1 except for heating the film material by using a heating roll of 260°C and a cooling roll of 25°C during one second. Then, same tests as in Example 1 were conducted. Results thereof are shown in table 1.

### (Example 3)

A film material with 4-layer structure was obtained in the same manner as in Example 1 except for changing the amount of hexenyl methacrylate to 1.8 parts and substituting di-t-butylperoxide (product name Kayabutyl D made by Kayaku Akzo Corporation, one-minute half-life temperature of 192°C) for 2,2-di-t-butylperoxybutane in the time of preparing the crosslinkable and polymerizable composition (A). Except for using this film material and setting the temperature of the heating roll to 260°C, a composite with 3-layer structure was obtained through heating in the same manner as in Example 1. Then, same tests as in Example 1 were conducted. Results thereof are shown in table 1.

### (Example 4)

A film material with 4-layer structure was obtained in the same manner as in Example 3. Except for using this film material and setting the temperature of the cooling roll to 50°C, a composite with 3-layer structure was obtained through heating in the same manner as in Example 3. Then, same tests as in Example 1 were conducted. Results thereof are shown in table 1.

### (Example 5)

A film material with 4-layer structure (copper foil / cross-linked resin (A) / not-cross-linked resin (B) / PEN) was obtained in the same manner as in Example 1 except for changing the amount of hexenyl methacrylate to 1.8 parts at the time of preparing the crosslinkable and polymerizable composition (A), substituting 2,3-dimethyl-2,3-diphenylbutane (product name Nofmer BC-90, made by NOF CORPORATION, one-minute half-life temperature of 285 °C) in 2 parts for di-t-butylperoxide at the time of preparing the crosslinkable and polymerizable composition (B) and changing the heating condition with the inert oven to 180°C and two minutes. The bulk polymerization reaction and the cross-linking reaction of the crosslinkable and polymerizable composition (A) progressed through the heating at 180°C by the inert oven, and the cross-linked resin (A) was obtained. After peeling the PEN film from the film material, a composite with 3-layer structure (copper foil / cross-linked resin (hard resin layer) / not-cross-linked resin (adhesive resin layer)) was obtained. Then, same tests as in Example 1 were conducted. Results thereof are shown together in table 1.

### (Example 6)

Onto an electrolytic copper foil (Type F0, thickness of 0.012 mm, made by Furukawa Circuit Foil Co., Ltd.), 70 parts of the crosslinkable and polymerizable composition (A) obtained in the same manner as in Example 1 was sprayed with a thickness of 70 µm. Next, 30 parts of the crosslinkable and polymerizable composition (B) obtained in the same manner as in Example 1 was sprayed with a thickness of 30 µm. A polyethylene naphthalate (PEN) film (made by Teijin DuPont Films Limited, thickness of 75 µm) was laminated onto the crosslinkable and polymerizable composition (B) side. Then, the obtained was heated in an inert oven at 130°C during one minute. The crosslinkable and polymerizable composition (A) and the crosslinkable and polymerizable composition (B) were bulk polymerized through the heating, and a film material with 4-layer structure (copper foil / not-cross-linked resin (A) / not-cross-linked resin (B) / PEN) was obtained.
After using the film material and cross-linking only the resin located at the copper foil side in the same manner as in Example 1, a composite with 3-layer structure was obtained. Then, same tests as in Example 1 were conducted. Results thereof are shown in table 1.

### (Example 7)

The crosslinkable and polymerizable composition (A) obtained in the same manner as in Example 1 except for changing the amount of hexenyl methacrylate to 1.8 parts was applied with a thickness of 30 µm onto an electrolytic copper foil (Type F0, thickness of 0.012 mm, made by Furukawa Circuit Foil Co., Ltd.), and the obtained was heated in an inert oven at 130°C during one minute to be subjected to a bulk polymerization. Next, using a heating roll and heating at 260°C during one second from the copper foil side, then a hard resin layer was formed. The crosslinkable and polymerizable composition (A) obtained in the same manner as in Example 1 except for changing the amount of hexenyl methacrylate to 1.8 parts was applied with a thickness of 10 µm onto the hard resin layer, and the obtained was heated in the inert oven at 130°C during one minute to be subjected to a bulk polymerization. Thus, a composite with 3-layer structure of copper foil / cross-linked resin (hard resin layer) / not-cross-linked resin (adhesive resin layer) was obtained. Then, same tests as in Example 1 were conducted. Results thereof are shown together in table 1.

### (Comparative Example 1)

Obtaining a film material with 4-layer structure (copper foil / not-cross-linked resin (A) / not-cross-linked resin (B) / PEN) in the same manner as in Example 3, but in a different manner from Example 3, without heating by the pair of the heating roll and the cooling roll, the PEN film was peeled off from the film material, and a composite with 3-layer structure (copper foil / not-cross-linked resin (A) / not-cross-linked resin (B)) was obtained. Thus prepared composites were tried to be laminated together, however, a multilayer circuit board could not be manufactured because of lower adhesion properties of copper foils.

### (Comparative Example 2)

A film material with 4-layer structure (copper foil / not-cross-linked resin (A) / not-cross-linked resin (B) / PEN) was obtained in the same manner as in Example 3. The film material was heated from both the copper foil side and the PEN film side at 260°C during one second by heating rolls. Through the heating, both the not-cross-linked resin (A) and the not-cross-linked resin (B) were cross-linked. The PEN film was peeled off from the obtained film material, and a composite with 3-layer structure (copper foil / cross-linked resin (A) / cross-linked resin (B)) was obtained. Thus prepared composites were tried to be laminated together, however, a multilayer circuit board could not be manufactured because of not flowing of adhesive resin layers and low adhesion properties between the composites.

### (Comparative Example 3)

Tried was to obtain a 4-layer structure bulk polymerized resin film in the same manner as in Example 1 except for dissolving the polymerizable compositions (A) and (B) into a solvent, however, when the solvent was removed, the hard resin layer and the adhesive layer could not be formed into a film-like shape, the two kinds of polymerizable compositions became to mix together in a solvent vaporizing process and foam was generated, and as a result a film could not be obtained.

As understood from the above-described results, by subjecting a fibrous material impregnated with a crosslinkable and polymerizable composition to a bulk polymerization to obtain a prepreg and then heating one face of the prepreg and cooling the other face, a composite for multilayer circuit board in which a metal foil, a hard resin layer and an adhesive resin layer are laminated in this order can be easily obtained (Examples 1 to 4).

As additionally understood, by using a crosslinkable and polymerizable composition A containing a cross-linking agent with a lower decomposition temperature and a crosslinkable and polymerizable composition B containing a cross-linking agent with a higher decomposition temperature, and heating at a temperature higher than or equal to a temperature where the cross-linking agent with the lower decomposition temperature starts to act and lower than a temperature where the cross-linking agent with the higher decomposition temperature does not start to act, a composite for multilayer circuit board in which a metal foil, a hard resin layer and an adhesive resin layer are laminated in this order can be easily obtained (Examples 5 to 7).

It is understood that, by using the composite according to the present invention, a multilayer circuit board with high adhesion properties between layers, superior in lamination properties and high reliability can be manufactured with high yield rate.

## Claims

1. A composite for multilayer circuit board, comprising:
a layer of metal foil;
a hard resin layer containing a hard resin obtained by bulk polymerization reaction (1) and cross-linking reaction; and
an adhesive resin layer containing an adhesive resin obtained by bulk polymerization reaction (2),
said layer of metal foil, said hard resin layer and said adhesive resin layer being laminated in this order.

2. The composite for multilayer circuit board as set forth in claim 1, wherein at least either one of said hard resin layer or said adhesive resin layer includes cycloolefin polymer.

3. The composite for multilayer circuit board as set forth in claim 1 or 2, wherein said adhesive resin layer further contains a cross-linking agent (2).

4. A manufacturing method of a composite for multilayer circuit board, comprising:
forming an intermediate composite (A) by integrating a layer of metal foil and a crosslinkable resin layer containing a resin obtained by bulk polymerization reaction and a cross-linking agent (1); and
applying heat to said intermediate composite (A) from the layer of metal foil side to subject a limited region of said crosslinkable resin layer adjacent to the metal foil to cross-linking reaction thereby said crosslinkable resin layer becomes to comprise a hard resin layer containing a hard resin obtained by bulk polymerization reaction and cross-linking reaction and an adhesive resin layer containing an adhesive resin obtained by bulk polymerization reaction.

5. The manufacturing method of a composite for multilayer circuit board as set forth in claim 4, wherein the cross-linking reaction of said intermediate composite (A) takes place under a condition where a surface of said crosslinkable resin layer far from the layer of metal foil has a temperature lower than or equal to a one-minute half-life temperature of said cross-linking agent (1).

6. The manufacturing method of a composite for multilayer circuit board as set forth in claim 4 or 5, wherein said intermediate composite (A) is obtained by applying a crosslinkable and polymerizable composition containing a bulk polymerizable monomer and said cross-linking agent (1) on said metal foil to form a coated film of said composition and applying heat to said coated film to be bulk polymerized.

7. A manufacturing method of a composite for multilayer circuit board, comprising:
forming an intermediate composite (B) by arranging a layer of metal foil, a crosslinkable resin layer containing a resin obtained by bulk polymerization reaction (3) and a cross-linking agent (α), and an adhesive resin layer containing an adhesive resin obtained by bulk polymerization reaction (4) in this order to be integrated to each other; and
heating said intermediate composite (B) to cross-link at least in part of said resin contained in said crosslinkable resin layer such that said crosslinkable resin layer becomes to be a hard resin layer containing a hard resin obtained by bulk polymerization reaction and cross-linking reaction.

8. The manufacturing method of a composite for multilayer circuit board as set forth in claim 7, wherein said adhesive resin layer contains a cross-linking agent (β) having a one-minute half-life temperature higher than that of said cross-linking agent (α).

9. The manufacturing method of a composite for multilayer circuit board as set forth in claim 7 or 8, wherein
said intermediate composite (B) is obtained by:
applying a crosslinkable and polymerizable composition (a) containing a bulk polymerizable monomer and said cross-linking agent (α) on said metal foil;
applying a polymerizable composition (b) containing a bulk polymerizable monomer on said crosslinkable and polymerizable composition (a) applied on said metal foil; and
bulk polymerizing said crosslinkable and polymerizable composition (a) and the polymerizable composition (b) to form respectively the crosslinkable resin layer and the adhesive resin layer.

10. The manufacturing method of a composite for multilayer circuit board as set forth in claim 7 or 8, wherein
said intermediate composite (B) contains a fibrous material in said crosslinkable resin layer and/or said adhesive resin layer, and
said intermediate composite (B) is obtained by:
applying a crosslinkable and polymerizable composition (a) containing a bulk polymerizable monomer and said cross-linking agent (α) on one surface of said fibrous material;
applying a polymerizable composition (b) containing a bulk polymerizable monomer on the other surface of said fibrous material;
laminating said metal foil on said crosslinkable and polymerizable composition (a) applied on the one surface of said fibrous material; and
bulk polymerizing said crosslinkable and polymerizable composition (a) and said polymerizable composition (b) to form respectively said crosslinkable resin layer and said adhesive resin layer.

11. The manufacturing method of a composite for multilayer circuit board as set forth in claim 7 or 8, wherein
said intermediate composite (B) is obtained by:
applying a crosslinkable and polymerizable composition (a) containing a bulk polymerizable monomer and said cross-linking agent (α) on said metal foil and then forming said crosslinkable resin layer through a bulk polymerization reaction (3); and
applying a polymerizable composition (b) containing a bulk polymerizable monomer on said crosslinkable resin layer formed on said metal foil and then forming said adhesive resin layer through a bulk polymerization reaction (4).

12. A manufacturing method of a composite for multilayer circuit board, comprising:
applying a crosslinkable and polymerizable composition (a) containing a bulk polymerizable monomer and a cross-linking agent (α) on a metal foil and then forming a crosslinkable resin layer through a bulk polymerization reaction (5);
cross-linking at least in part of said crosslinkable resin layer to form a hard resin layer containing a hard resin obtained by bulk polymerization reaction and cross-linking reaction; and
applying a polymerizable composition (b) containing a bulk polymerizable monomer on said hard resin layer and then forming an adhesive resin layer containing an adhesive resin obtained by bulk polymerization reaction through a bulk polymerization reaction (6).

13. A single sided circuit board for multilayer circuit board,
wherein
a conductive circuit is formed by patterning said layer of the metal foil of the composite for multilayer circuit board as set forth in any one of claims 1 to 3,
a via hole is formed to penetrate through said hard resin layer and said adhesive resin layer and to make the conductive circuit exposed at a bottom surface side of the via hole, and
a conductor is given into said via hole.

14. A method of manufacturing a multilayer circuit board comprising a plurality of circuit boards, wherein the method includes
overlapping two or more of the single sided circuit board for multilayer circuit board as set forth in claim 13 or overlapping said single sided circuit board for multilayer circuit board and other circuit board, followed by heat pressing to laminate.
